# EUROPÄISCHE PATENTSCHRIFT

(11) **EP 1 059 020 B1**
(45) Veröffentlichungstag und Bekanntmachung des Hinweises auf die Patenterteilung: **24.10.2001**
(21) Anmeldenummer: 99903528.0
(22) Anmeldetag: 10.02.1999
(51) Int. Cl.: H05K 7/14

(54) **ELEKTRONISCHES GERÄT**
ELECTRONIC APPARATUS
APPAREIL ELECTRONIQUE

(30) Priorität: 24.02.1998 AT 33298
(43) Veröffentlichungstag der Anmeldung: 13.12.2000
(73) Patentinhaber: Siemens Aktiengesellschaft Österreich, 1210 Wien (AT)
(72) Erfinder: WEINMEIER, Harald, A-1210 Wien (AT); HALBREINER, Erich, A-1190 Wien (AT)
(74) Vertreter: Matschnig, Franz, Dipl.-Ing.
(86) Internationale Anmeldenummer: AT9900035
(87) Internationale Veröffentlichungsnummer: WO9944404

(56) Entgegenhaltungen:
- EP-A- 0 793 407
- DE-A- 4 422 114
- JP-A- 8 222 869

## Beschreibung

Die Erfindung bezieht sich auf ein elektronisches Gerät mit einem Gehäuse, einer Rückwand und zumindest einer in dem Gehäuse untergebrachten Leiterplatte, welche im wesentlichen senkrecht auf die Rückwand steht.

Geräte dieser Art sind in vielen Ausführungsformen bekannt, doch sind die gestellten Anforderungen im wesentlichen die gleichen. Insbesondere soll das Zusammenstellen des Gerätes rasch und nach Möglichkeit ohne Hilfsmittel möglich sein, es soll ein Berührschutz bei mit dem Netz in Verbindung stehenden Geräten gegeben sein, und es soll auch eine ästhetische Gestaltung des Gehäuses möglich sein. Elektronische Geräte enthalten meist auch Leistungshalbleiter, die gekühlt werden müssen. Die Halbleiter sind elektrisch an der Leiterplatte befestigt und mechanisch bzw. in thermischem Kontakt stehend mit einem Kühlkörper oder einer größeren metallischen Kühlfläche verbunden.

Bekannt ist beispielsweise ein Kunststoffgehäuse, bei dem die Rückwand, die beiden Seitenwände und die Ober- und Unterwand einstückig ausgebildet sind und das eine Vorderwand besitzt, welche die in das Gehäuse eingeschobene Leiterplatte mit ihren Aufbauten nach vorne hin abdeckt. Zur Kühlung bestimmter Bauelemente sind auf der Leiterplatte Kühlbleche montiert, was mechanisch und fertigungstechnisch einen großen Aufwand bedeutet. Die Leistungshalbleiter sind nämlich einerseits mit der Leiterplatte verlötet und andererseits mechanisch auf den Kühlblechen mit Hilfe von Klammern gehalten. Dies bedeutet aber, dass die Kühlbleche mechanisch starr mit der Leiterplatte verbunden sein müssen, da es sonst widrigenfalls im Laufe der Zeit zu einer Beschädigung der Lötstellen der Leistungshalbleiter und ihrer Anschlüsse kommen kann. Bei Geräten, die auf Normmontageschienen montiert werden sollen, ergibt sich als zusätzliche Forderung, dass das Gerät mit seiner Rückwand auf einer Schiene aufgehängt wird und die entsprechende Kräfteeinleitung zu berücksichtigen ist.

In der DE 44 22 114 A1 ist ein Gehäusetopf fiir Elektronikmodule z.B. in Kraftfahrzeugen beschrieben. Der Gehäusetopf ist einseitig offen gestaltet; das Verschließen desselben erfolgt mit einem gesonderten Deckel, der als Kühlkörper für die Leistungsbauelemente ausgestaltet sein kann und mit der Leiterplatte in fester Verbindung steht. Dem Ableiten von Wärme von Leistungsbauelementen dient eine verschraubte Befestigung des Gehäusetopfes mit einem Kühlkörper, welcher einstückig mit dem Deckel ausgebildet ist.

Bei einem aus der EP 0 793 407 A2 bekannt gewordenen elektronischen Gerät ist vorgesehen, dass die einzige Schaltungsplatine eine Gehäusewand bildet und an ihrer Außenseite mit Kühlrippen zur Wärmeabfuhr versehen ist. Die Leiterplatte wird dabei mechanisch von dem Gehäuse getragen, welches einen Kunststoffsockel mit nach unten abstehenden Flachsteckern besitzt.

Dem gegenüber liegt die Aufgabe der Erfindung darin, ein elektronisches Gerät der eingangs angegebenen Art, bei welchem zumindest eine Leiterplatte im wesentlichen senkrecht zur Rückwand steht zu schaffen, bei dem bei ausreichender mechanischer Festigkeit und unter Berücksichtigung der Sicherheitsforderungen ein preisgünstiger Aufbau möglich ist.

Diese Aufgabe wird mit einem Gerät der eingangs genannten Art erfindungsgemäß dadurch gelöst, dass die Rückwand ein von dem Gehäuse unabhängiger Teil ist, mit welchem zu kühlende Bauelemente in thermischem Kontakt stehen, welcher das Gehäuseinnere nach hinten abschließt, wobei die Leiterplatte mit der Rückwand durch von dieser abstehende und in die Leiterplatte eingreifende Haltemittel tragend verbunden ist

Durch die erfindungsgemäße Maßnahme wird zunächst erzielt, dass die Leiterplatte mechanisch von der Rückwand getragen wird, was sich auch bei einer Montage auf Montageschienen günstig auswirkt, wobei die Leiterplatte im Bedarfsfall dennoch von dem später aufzuschiebenden Restgehause abgestützt sein kann. Ein besonderer Vorteil ergibt sich jedoch daraus, daß nun auf der Leiterplatte angeordnete Halbleiter unter Zuhilfenahme der Rückwand oder von Teilen der Rückwand gekühlt werden können, da die Rückwand mit einer oder mehreren, von ihr senkrecht abstehenden Leiterplatten mechanisch eine Einheit bildet.

Die Befestigung der Leiterplatte an der Rückwand kann billig und sicher erfolgen, wenn die Haltemittelbohrungen der Leiterplatte durchsetzende und verschränkbare Stege beinhalten.

Für den Zusammenbau vereinfachend wirkt es sich aus, falls die Haltemittelbohrungen der Leiterplatte zugeordnete Justierstifte beinhalten

Wenn die Rückwand aus einer Außenplatte und einer Innenplatte besteht, wobei die Innenplatte Bereiche aufweist, die in Abstand von der Außcnplatte liegen und von welchen die Haltemittel abstehen, ergibt sich eine besondere Flexibilität bei der Kuhlung von Bauelementen und auch eine verbesserte Kühlwirkung, da die abstehenden Bereiche an beiden Seiten von Luft umspült werden können Dabei ist es zweckmäßig, wenn die Innenplatte teilwetse an der Außenplatte anliegt und im wesentlichen parallel zur Außenplatte, in Abstand von dieser verlaufend Bereiche besitzt. In diesem Fall ist es für die Kühlung vorzuziehen. wenn zumindest die Innenplatte aus Metall besteht

Im Hinblick auf eine kostengünstige Fertigung empfiehlt es sich, wenn die Innenplatte mit der Außenplatte vernietet oder vertoxt ist

Die Ruckwand kann an ihrer Außenseite Hakenelemente zur Aufhangung an einer Montageschiene besitzen, was sich insbesondere bei einer metallischen Ruckwand als emfache Ausfuhrungsform erweist. Dabei kann die Rückwand unterhalb der Hakenelemente zumindest ein lösbares, an der Montageschiene angreifendes Rückhalteelement besitzen.

Bei einer einfachen und zweckmäßigen Variante der Erfindung ist es möglich, dass die zu kühlenden Bauelemente mit der Innenplatte der Rückwand in Kontakt stehen, wobei in diesem Fall die Innenplatte direkt mit der Leiterplatte verbunden sein kann, was in manchen Fällen mechanische Vorteile ergibt, da eine Befestigung zwischen Rückwand und Leiterplatte nicht vollständig am Rande der Leiterplatte erfolgen muß.

Eine der Forderung nach billiger Montage entgegenkommende Variante zeichnet sich dadurch aus, daß die zu kuhlenden Bauelemente mit Hilfe von U-förmigen Haltefedern gegen die Rückwand oder deren Innenplatte gepreßt sind, wobei die Haltefedern mit ihren Füßen Durchbrüche der Rückwand durchsetzen und mit ihrem Steg an dem Bauelement anliegen.

Zur Erleichterung der Montage ist es vorzuziehen, falls die Frontwand, die Seitenwände sowie die Ober- und Unterwand des Gehäuses einstuckig ausgebildet sind und das Gehäuse dabei aus Kunststoff besteht.

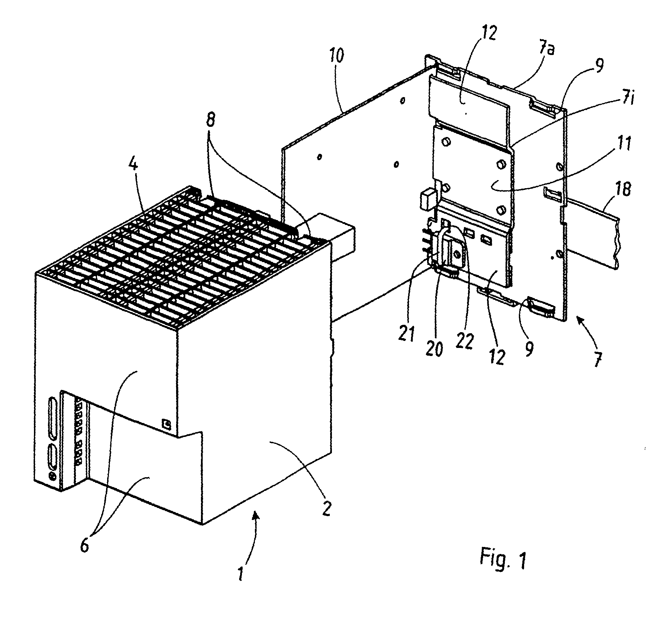

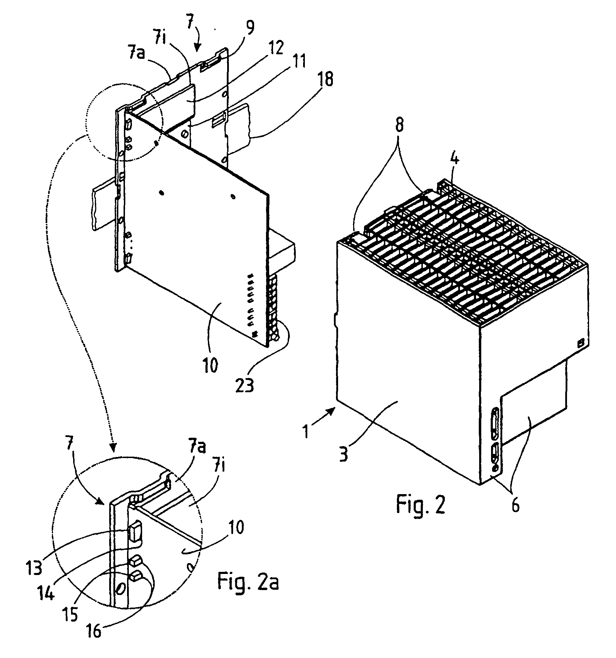

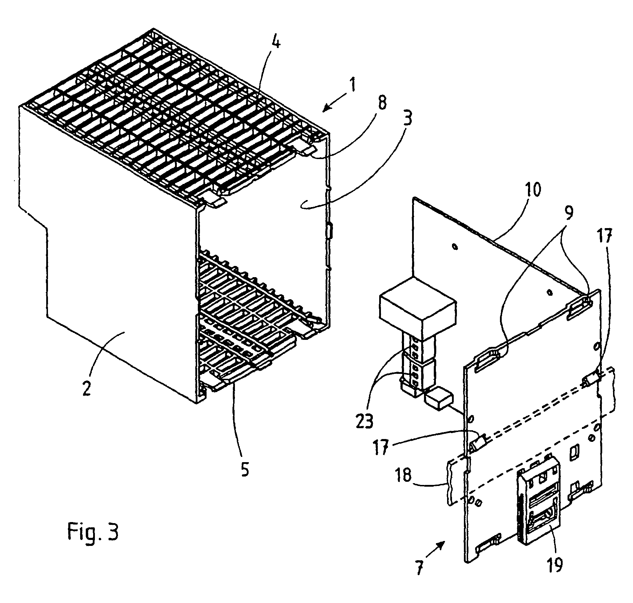

Die Erfindung samt weiterer Vorteile ist im folgenden anhand einer beispielsweisen Ausführungsform naher erlautert, die in der Zeichnung veranschaulicht ist. In dieser zeigen
■ Fig. 1 ein erfindungsgemäßes Gerät, teilweise zerlegt, in einer perspektivischen Ansicht von vorne, oben und rechts,
■ Fig. 2 eben dieses Gerät in einer perspektivischen Ansicht von vorne, oben und links,
■ Fig. 2a ein Detail aus Fig. 2 in vergrößertem Maßstab und
■ Fig. 3 das in Fig. 1 and 2 gezeigte Ausführungsbeispiel der Erfindung in einer perspektivischen Ansicht von hinten, rechts und oben

Gemäß den Figuren weist ein Gehäuse 1 für ein elektronisches Gerät eine rechte Seitenwand 2, eine linke Seitenwand 3, eine obere Wand 4, eine untere Wand 5 und eine Vorderwand 6 auf, wobei alle diese Wände einstückig aus Kunststoff hergestellt sind Wie der Zeichnung entnehmbar, sind die obere Wand 4 und die untere Wand 5 mit Durchbrechungen gitterformig ausgestaltet, sodaß eine Luftströmung von oben nach unten durch das Gehäuseinnere erfolgen kann

Dem Gehause 1 ist eine Ruckwand 7 zugeordnet, welche im zusammengebauten Zustand des Gerates das Gehäuseinnere nach hinten abschließt. Um die Rückwand 7 mit dem Gehause 1 mechanisch zu verbinden, stehen von den Hinterkanten des Gehauses vier federnde Hakenlaschen 8 ab, welche Ausnehmungen 9 in der Ruckwand 7 durchsetzen konnen und sich mit dieser Ruckwand verhaken

Das Gerat nach der Erfindung weist eine Leiterplatte 10 auf. die im vorliegenden Fall an der linken Seite des Gerates vertikal verlauft und mit der Ruckwand mechanisch verbunden ist, was nachstehend naher erlautert wird. Die Ruckwand 7 besteht aus einer im wesentlichen ebenen Außenplatte 7a sowie aus einer Innenplatte 7i, wobei die Innenplatte 7i einen ebenen Mittelbereich 11 aufweist, mit dem sie an der Außenplatte 7a anliegt. Dieser Mittelbereich 11 ist mit der Außenplatte 7a im vorliegenden Fall vertoxt, einer Abart des Nietens ohne Verwendung von Fremdmaterial Die Innenplatte 7i besteht ebenso wie die Außenplatte 7a aus Metall, beispielsweise aus Aluminium. Vor allem die Außenplatte 7a kann jedoch auch aus einem anderen Material, z.B aus Kunststoff bestehen Von den beiden Seitenbereichen 12 der Innenplatte 7i stehen Stege 13 ab, welche rechteckformige Ausnehmungen 14 der Leiterplatte 10 durchsetzen und sodann verschränkt sind. Im Detail ist dies aus Fig. 2a erkennbar, wo auch weiters zu sehen ist, daß von den Seitenbereichen 12 der Innenplatte 7i abstehende Justierstifte in Bohrungen 16 der Leiterplatte eingreifen bzw diese durchsetzen

Aus obigem ist ersichtlich, daß die Leiterplatte 10 mit Hilfe der Stege 13 und der Justierstifte 15 mit der Ruckwand 7, namlich mit deren Innenplatte 7i mechanisch stabil verbunden ist, sodaß die Leiterplatte 7 von der Ruckwand getragen werden kann. Dies ist insofern von Bedeutung, als bei dem vorliegenden Ausführungsbeispiel an der Außenseite der Rückwand 7 Hakenelemente 17, je in Form von ausgestanzten und ausgebogenen Laschen, vorgesehen sind, mit deren Hilfe die Rückwand 7 und damit auch das gesamte Gerät auf eine Montageschiene 18 gehängt werden kann, die in der Zeichnung angedeutet ist, wobei besonders auf Fig. 3 bezug genommen wird Die Rückwand 7 und damit das Gerät kann an der Montageschiene 18 mit Hilfe eines Rückhalteelements 19 gesichert werden, wobei im vorliegenden Fall das Rückhalteelement als federnder Halteschieber ausgebildet ist, der zum Lösen nach unten gezogen werden muß.

Da für die Erläuterung der Erfindung nicht erforderlich, sind die meisten, ublicherweise auf der Leiterplatte 10 angeordneten Bauteile weggelassen Insbesondere in Fig. 1 erkennt man jedoch ein Bauelement 20, je einen Leistungstransistor, der mit seinen Anschlüssen mit der Leiterplatte 10 verlötet ist und mit seinem Gehäuse an dem Seitenbereich 12 der Innenplatte 7i anliegt Um einen guten thermischen Kontakt zu gewährleisten, ist das Bauelement 20 mit einer bekannten U-förmigen Haltefeder 21 gegen den Seitenbereich 12 gepreßt, wobei die Haltefeder mit ihren Füßen Durchbrüche 22 durchsetzt und mit ihrem Stegteil an dem Bauelement 20 anliegt

Bei dem gezeigten Ausführungsbeispiel ist die Ruckwand 7 zweiteilig ausgeführt, d h sie besteht aus einer Außenplatte 7a und aus einer Innenplatte 7i Es ist jedoch auch moglich, eine durchgehende Ruckwand zu verwenden, d h praktisch nur die Außenplatte 7a ohne Innenplatte 7i, wobei durch entsprechende Stanz- und Biegevorgange die benotigten Stege oder Justierstifte so weit aus der Ruckwand 7 herausgebogen werden konnen daß eine sichere Verbindung mit der Leiterplatte 10 moglich ist Allerdings bietet die in dem Ausfuhrungsbeispiel gezeigte zweiteilige Ausfuhrung der Ruchwand 7 auch den Vorteil daß die Seitenbereiche 12 beidseitig freiliegen und dadurch von kuhlender Luft umströmt werden konnen Es gibt jedoch bezüglich der Ausführung der Ruckwand 7 kaum Einschränkungen, wobei es beispielsweise möglich ist. eine Rückwand aus einem einzigen Blech mäanderformig zu biegen, wodurch sich nicht nur ins Innere vorspringende und zur Befestigung geeignete Teilbereiche ergeben, sondern auch die Gesamtoberfläche im Sinne einer verbesserten Kühlung vergroßert wird.

Zur Montage des Gerätes wird die Rückwand mit den Stegen 13 und den Justierstiften 15 in die Leiterplatte 10 eingesetzt, und sodann werden die Stege 13 verschränkt, wodurch sich die gewünschte mechanische Verbindung zwischen Leiterplatte 10 und Ruckwand 7 ergibt. Daraufhin wird das zu kühlende Bauelement 20, welches elektrisch bereits mit der Leiterplatte 10 kontaktiert ist, mit Hilfe der Haltefeder 21 auf der Rückwand montiert, und die bestückte Leiterplatte 10 wird zusammen mit der Ruckwand 7 in das Gehäuse 1 eingeschoben. Auf der Leiterplatte sind auch - in Fig. 3 ersichtliche - Anschlußklemmen 23 montiert, die sodann durch die Vorderwand 6 hindurch bedienbar sind, was Fig 1 illustriert.

Der Rückwand 7 kommt eine Anzahl von Funktionen zu, namlich die Möglichkeit der Montage auf einer Montageschiene 18, die Wirkung als Kuhleinrichtung, die starre Verbindung mit der Leiterplatte 10, ein Beruhrschutz von der Hinterseite sowie eine Übertragung des Gewichtes der Leiterplatte 10 auf die Montageschiene 18 Uberdies dient die Rückwand als Träger für die U-förmige Haltefeder 21 des zu kühlenden Bauelementes 20. Es versteht sich, daß im allgemeinen nicht nur ein einziger Leistungstransistor zu kühlen ist, sondern mehrere elektronische Bauelemente, die in analoger Weise angeordnet sind, wie das einzige bei dem Ausführungsbeispiel gezeigte Bauelement 20

Im Gegensatz zu bekannten Geräten, bei welchen das Gehäuse an der Halteschiene gehalten ist, sodaß nach Abnehmen der Vorderwand die Leiterplatte mit ihren Aufbauten nach vorne herausgezogen werden kann, hängt bei der Erfindung die Rückwand an der Montageschiene 18, und nach Abziehen des Gehäuses 1 nach vorne verbleibt das eigentliche elektronische Gerat weiterhin an der Montageschiene, nun ohne Gehause Dies kann in manchen Fällen auch für Wartungszwecke von Vorteil sein Bei den Geraten nach dem Stand der Technik kommt somit die tragende Funktion immer dem Gehause zu, wogegen bei der Erfindung die Ruckwand die Leiterplatte bzw auch mehrere Leiterplatten tragt Die Anzahl der zusammenzusetzenden Teile reduziert sich bei der Erfindung, da nach dem Stand der Technik die Leiterplatte mit Kühlkörpern, das Gehause und eine Frontwand vorhanden sind, bei der Erfindung jedoch nur noch zwei Teile. namlich das Gehause und die Ruckwand samt Leiterplatte

## Patentansprüche

1. Elektronisches Gerät mit einem Gehäuse (1), einer Rückwand (7) und zumindest einer in dem Gehäuse untergebrachten Leiterplatte (10), welche im wesentlichen senkrecht auf die Rückwand steht,
wobei
die Rückwand (7) ein von dem Gehäuse (1) unabhängiger Teil ist, mit welchem zu kühlende Bauelemente (20) in thermischem Kontakt stehen, welcher das Gehäuseinnere nach hinten abschließt, wobei die Leiterplatte (10) mit der Ruckwand durch von dieser abstehende und in die Leiterplatte eingreifende Haltemittel (13, 15) tragend verbunden ist

2. Gerät nach Anspruch 1, **dadurch gekennzeichnet, dass** die Haltemittel Ausnehmungen (14) der Leiterplatte (10) durchsetzende und verschränkbare Stege (13) beinhalten.

3. Gerät nach Anspruch 1 oder 2, **dadurch gekennzeichnet, dass** die Haltemittel Bohrungen (16) der Leiterplatte (10) zugeordnete Justierstifte (15) beinhalten.

4. Gerät nach einem der Ansprüche 1 bis 3, **dadurch gekennzeichnet, dass** die Rückwand (7) aus einer Außenplatte (7a) und einer Innenplatte (7i) besteht, wobei die Innenplatte Bereiche (12) aufweist, die in Abstand von der Außenplatte liegen, und von welchen die Haltemittel (13, 15) abstehen.

5. Gerat nach Anspruch 4, **dadurch gekennzeichnet, dass** die Innenplatte (7i) teilweise an der Außenplatte (7a) anliegt und im wesentlichen parallel zur Außenplatte, in Abstand von dieser verlaufende Bereiche (12) besitzt.

6. Gerat nach Anspruch 5, **dadurch gekennzeichnet, dass** zumindest die Innenplatte (7i) aus Metall besteht.

7. Gerät nach einem der Ansprüche 4 bis 6, **dadurch gekennzeichnet, dass** die Innenplatte (7i) mit der Außenplatte (7a) vernietet oder vertoxt ist

8. Gerat nach einem der Ansprüche 1 bis 7, **dadurch gekennzeichnet, dass** die Ruckwand (7) an ihrer Außenseite Hakenelemente (17) zur Aufhangung an einer Montageschiene besitzt.

9. Gerät nach Anspruch 8, **dadurch gekennzeichnet, dass** die Rückwand (7) unterhalb der Hakenelemente (17) zumindest ein lösbares, an der Montageschiene angreifendes Rückhalteelement (19) besitzt.

10. Gerät nach einem der Ansprüche 2 bis 9, **dadurch gekennzeichnet, dass** zu kuhlende Bauelemente (20) mit der Innenplatte (7i) der Rückwand (7) in Kontakt stehen

11. Gerät nach einem der Ansprüche 1 oder 10, **dadurch gekennzeichnet, dass** die zu kühlenden Bauelemente (20) mit Hilfe von U-förmigen Haltefedern (21) gegen die Rückwand (7) oder deren Innenplatte (7i) gepresst sind, wobei die Haltefedern mit ihren Füßen Durchbrüche (22) der Rückwand durchsetzen und mit ihrem Stegteil an dem Bauelement anliegen.

12. Gerät nach einem der Ansprüche 1 bis 11, **dadurch gekennzeichnet, dass** die Frontwand, die Seitenwände sowie die Ober- und Unterwand des Gehäuses (1) einstückig ausgebildet sind.

13. Gerät nach Anspruch 12, **dadurch gekennzeichnet, dass** das Gehäuse (1) aus Kunststoff besteht

## Claims

1. Electronic device having a housing (1), a rear wall (7) and at least one printed circuit board (10) which is accommodated in the housing and which is positioned substantially perpendicular with respect to the rear wall, wherein the rear wall (7) is a part which is independent of the housing (1) and with which components (20) which are to be cooled are in thermal contact and which part rearwardly closes off the inside of the housing, wherein the printed circuit board (10) is connected in a supporting manner to the rear wall by virtue of holding means (13, 15) which protrude from said rear wall and engage into the printed circuit board.

2. Device according to claim 1, **characterised in that** the holding means include cross-pieces (13) which pass through cut-outs (14) in the printed circuit board (10) and engage therein.

3. Device according to claim 1 or 2, **characterised in that** the holding means include alignment pins (15) which are allocated to bores (16) in the printed circuit board (10).

4. Device according to any one of the claims 1 to 3, **characterised in that** the rear wall (7) consists of an outer plate (7a) and an inner plate (7i), wherein the inner plate comprises regions (12) which are spaced apart from the outer plate and from which the holding means (13, 15) protrude.

5. Device according to claim 4, **characterised in that** the inner plate (7i) lies partially against the outer plate (7a) and comprises regions (12) which extend substantially in parallel with the outer plate and at a spaced interval therefrom.

6. Device according to claim 5, **characterised in that** at least the inner plate (7i) consists of metal.

7. Device according to any one of the claims 4 to 6, **characterised in that** the inner plate (7i) is rivetted to the outer plate (7a) or connected thereto by toxing.

8. Device according to any one of the claims 1 to 7, **characterised in that** on its outer side the rear wall (7) comprises hook elements (17) for suspension on a mounting rail.

9. Device according to claim 8, **characterised in that** below the hook elements (17) the rear wall (7) comprises at least one releasable retaining element (19) which engages the mounting rail.

10. Device according to any one of the claims 2 to 9, **characterised in that** components (20) which are to be cooled are in contact with the inner plate (7i) of the rear wall (7).

11. Device according to any one of the claims 1 to 10, **characterised in that** the components (20) which are to be cooled are pressed against the rear wall (7) or the inner plate (7i) thereof with the aid of U-shaped holding springs (21), wherein the holding springs pass with their feet through openings (22) in the rear wall and lie with their cross-piece part against the component.

12. Device according to any one of the claims 1 to 11, **characterised in that** the front wall, the lateral walls and the upper and lower wall of the housing (1) are formed in one piece.

13. Device according to claim 12, **characterised in that** the housing (1) consists of synthetic material.

## Revendications

1. Appareil électronique comportant un boîtier (1), une paroi arrière (7) et au moins une plaquette à circuits imprimés (10) qui est logée dans le boîtier et qui est disposée essentiellement perpendiculairement sur la paroi arrière, dans lequel
la paroi arrière (7) est une partie qui est indépendante du boîtier (1) et avec laquelle des composants (20) devant être refroidis sont placés en contact et qui ferme l'intérieur du boîtier en direction de l'arrière, la plaquette à circuits imprimés (10) étant reliée à la paroi arrière, en y étant supportée par des moyens de retenue (13, 15) qui font saillie à partir de la paroi arrière et pénètrent dans la plaquette à circuits imprimés.

2. Appareil selon la revendication 1, **caractérisé en ce que** les moyens de retenue incluent des barrettes (13) qui traversent des évidements (14) de la plaquette à circuits imprimés (10) et peuvent être montées en crémaillère.

3. Appareil selon la revendication 1 ou 2, **caractérisé en ce que** les moyens de retenue incluent des broches d'ajustement (15), qui sont associées à des perçages (16) de la plaquette à circuits imprimés (10).

4. Appareil selon l'une des revendications 1 à 3, **caractérisé en ce que** la paroi arrière (16) est constituée par une plaque extérieure (7a) et une plaque intérieure (7i), la plaque intérieure comportant des parties (12), qui sont situées à distance de la plaque extérieure et à partir desquelles font saillie les moyens de retenue (13, 15).

5. Appareil selon la revendication 4, **caractérisé en ce que** la plaque intérieure (7i) s'applique en partie contre la plaque extérieure (7a) et possède des parties (12) qui sont sensiblement parallèles à la plaque extérieure et s'étendent à distance de cette dernière.

6. Appareil selon la revendication 5, **caractérisé en ce qu'**au moins la plaque intérieure (7i) est réalisée en un métal.

7. Appareil selon l'une des revendications 5 à 6, **caractérisé en ce que** la plaque intérieure (7i) est rivetée ou rivetée sans utilisation d'un matériau étranger à la plaque intérieure (7a).

8. Appareil selon l'une des revendications 1 à 7, **caractérisé en ce que** la paroi arrière (7) possède, sur sa face extérieure, des éléments en forme de crochets (17) permettant une suspension à un rail de montage.

9. Appareil selon la revendication 8, **caractérisé en ce que** la paroi arrière (7) possède, au-dessous des éléments en forme de crochets (17), au moins un élément de retenue arrière amovible (19), qui s'accroche au rail de montage.

10. Appareil selon l'une des revendications 2 à 9, **caractérisé en ce que** des composants (20) devant être refroidis sont en contact avec la plaque intérieure (7i) de la paroi arrière (7).

11. Appareil selon l'une des revendications 1 à 10, **caractérisé en ce que** les composants (20) devant être refroidis sont serrés à l'aide de ressorts de retenue en forme de U (21) contre la paroi arrière (7) ou sa plaque intérieure (7i), les ressorts de retenue traversant, par leurs pieds, des passages traversants (22) de la paroi arrière et s'appliquant, par leur élément en forme de barrette contre le composant.

12. Appareil selon l'une des revendications 1 à 11, **caractérisé en ce que** la paroi avant, les parois latérales ainsi que la paroi supérieure et la paroi inférieure du boîtier (1) sont agencées d'un seul tenant.

13. Appareil selon la revendication 12, **caractérisé en ce que** le boîtier (1) est réalisé en matière plastique.
